# EUROPEAN PATENT SPECIFICATION

(11) **EP 0 482 198 B1**
(45) Date of publication and mention of the grant of the patent: **03.12.1997**
(21) Application number: 91903586.5
(22) Date of filing: 06.02.1991
(51) Int. Cl.: H01L 39/12, H01L 39/22

(54) **Superconducting tunnel junction element comprising a magnetic oxide material and its use**
Supraleitendes Tunnelübergangselement mit magnetischem Oxidmaterial und seine Verwendung
Elément supraconducteur à jonction tunnel comprenant un matériau oxide magnétique et son application

(30) Priority: 11.05.1990 JP 119867/90; 19.12.1990 JP 403917/90
(43) Date of publication of application: 29.04.1992
(73) Proprietor: HITACHI, LTD., Chiyoda-ku, Tokyo 101 (JP)
(72) Inventor: KASAI, Masahiro, Hitachi-shi, Ibaraki 316 (JP); KANKE, Yoko, Katsuta-shi, Ibaraki 316 (JP); OHNO, Toshiyuki, Hitachi-shi, Ibaraki 319-12 (JP); KOZONO, Yuzoo, Hitachiohta-shi, Ibaraki 313 (JP); HANAZONO, Masanobu, Mito-shi, Ibaraki 310 (JP)
(74) Representative: Beetz & Partner Patentanwälte
(86) International application number: JP9100140
(87) International publication number: WO9118423

(56) References cited:
- EP-A- 0 342 039
- JP-A- 193 210
- JP-A-60 177 691
- JP-A-63 269 585
- JP-A-63 274 118
- WORLD PATENTS INDEX LATEST, Week 8915, Derwent Publications Ltd., London, GB; AN 89-110488 & JP-A-1 056 356
- JAPANESE JOURNAL OF APPLIED PHYSICS. vol. 29, no. 12, December 1990, TOKYO, JP; pages 2219-2222; MASAHIRO KASAI ET AL.: 'Current-voltage characteristics of YBa2Cu3Oy/La0.7Ca0.3MnOz/YBa2CU3Oy trilayered-type junctions'
- PATENT ABSTRACTS OF JAPAN, vol. 15, no. 295 (E-1094) 26 July 1991 & JP-A-3 105 807
- IEEE TRANSACTIONS ON MAGNETICS, Vol. MAG-23, No.2, (1987), 0.A. MUKHANOV et al.: "ULTIMATE PERFORMANCE OF THE RSFQ LOGIC CIRCUITS"
- Applied Physics, Vol. 56, NO.6, (1987), KIICHI NISHINO et al.: "Superconductive Transistor"
- Physica C, vol.153-155, 1988, pages 1769-1774; P.Fulde: "Current theories of the high-Tc superconducting materials"
- Solid State Technology, May 1990, pages 255-260; R.H.Koch: "SQUIDs Made from High Tempearture Superconductors"
- IEEE Electron Device Lett., vol. EDL-6, No.6, June 1985, pages 297-299; T.Nishino et al.: "Three Terminal Superconducting Device Using a Si Single Crystal Film"

## Description

This invention relates to superconducting elements utilizing oxide superconducting materials and more particularly to superconducting tunnel junction elements utilizing a proximity effect by superconductive electron pairs as defined in the first part of claim 1.

Prior art superconducting devices or what is called superconducting elements prepared using metallic superconductors have a lamination-type Josephson junction which is formed by interposing an extremely thin film of an insulator with several tens of Ångstroms (1 Angstrom = 0.1 nm) in thickness between superconducting materials.

For high-speed switching devices or highly sensitive magnetic sensors Josephson devices wherein an electrical insulator is sandwiched between superconducting materials such as Nb compounds or Pb compounds are used. Because of extreme difficulties in fabrication any attempts to prepare Josephson devices using SrTiO₃, Al₂O₃ as an insulator have not been successful.

EP-A-0 342 039 describes Josephson junction devices comprising Y₁Ba₂Cu₃O_{7-δ} (δ > 0.5) as a tunneling layer interposed between two superconducting layers of Y₁Ba₂Cu₃O_{7-δ} (0 ≤ δ < 0.5).

Document JP-A-1 056 356 (cf. World Patents Index Latest, Week 8915, Derwent Publications Ltd., London, GB, AN 89-110488) discloses high temperature superconducting materials comprising Ba, Y, Cu and O wherein Ba and/or Y is substituted by an element with a smaller diameter than Yttrium. By sandwiching superconducting layers with ferromagnetic layers, T_{c} and I_{c} are increased.

P. Fulde describes in " Current theories of the high-T_{c} superconducting materials ", Physica C 153-155 (1988) 1769-1774, two types of materials: La₂CuO₄ and YBa₂Cu₃O_{7-δ}, the latter being a superconductor for 0 ≤ δ < 0.6 and an antiferromagnet for δ > 0.6. This article deals only with theories of the high-T_{c} superconducting materials.

On the other hand, as superconducting devices having no Josephson junctions of the lamination type, superconducting transistors have been known. Fabrication of such transistors using oxide superconducting materials has been also very difficult because the gap length between the superconducting electrodes must be made very narrow in accordance with the short distance in penetration or seepage of the wave function into a semiconductor region.

Thereby, according to the prior art it has been difficult to fabricate the superconducting devices using oxide superconducting materials.

The underlying problem of the present invention is to provide superconducting tunnel junction elements applicable for superconducting devices using oxide superconducting materials.

This problem is solved according to the independent claim. The dependent claims pertain to prefered embodiments.

The general concept of the superconducting tunnel junction element of the present invention, which comprises a non-superconductive magnetic oxide material having two junction interfaces to oxide superconductors, the magnetic oxide material having a perovskite structure, is characterized in that
the magnetic oxide material is one of the following materials:
(La, Ca)₁Mn₁O_{y},
(La, Sr)₁Mn₁O_{y},
(La, A)₁B₁O_{y} (where A is at least more than one species of alkaline earth elements; B is at least one of Mn, Co, Fe and Ni),
Bi₁Mn₁O_{y},
Ba₁Fe₁O_{y},
Sr₁Co₁O_{y},
(La, A)₁B₁O_{y} (where A = Ba, Sr, Pb, Cd; B = Mn, Co),
[(Pr, Nd), (Ba, Sr)]₁Mn₁O_{y},
(Bi, Ca)₁Mn₁O_{y},
La₁(M, Mn)₁O_{y} (where M = Co, Ni, Cu, Cr),
Gd₁(Co, Mn)₁O_{y},

A₁(Fe, B)₁O_{y} (where A = Ba, Ca, Sr; B = Mo, Mn),
Bi₁Cr₁O_{y},
Ca₁Ru₁O_{y},
A₁(B, C)₁O_{y} (where A = Ba, Ca, Sr, Pb; B = Ni, Mn, Cr, Fe; C = W, Sb, Mo, U),
(Sr, La)₁(C, D)₁O_{y} (where C = Co, Ni; D = Nb, Sb, Ta),
y being from 2.7 to 3.3.

Elements in parentheses indicate that at least either one of them is present.

In accordance with a prefered embodiment of the superconducting tunnel junction element a magnetic oxide material is interposed in a lamination structure between oxide superconductors.

This prefered superconducting element of the present invention comprises a three-layered structure having an oxide magnetic substance interposed between oxide superconducting materials. In this structure of the superconducting element, the magnetic oxide material having perovskite structure and being interposed between the oxide superconducting materials is present in the form of a thick film.

According to a further prefered embodiment of the superconducting tunnel junction element of the present invention, the oxide superconductors are formed on the surface of the magnetic oxide material a gap structure being provided between the oxide superconductors.

In superconducting devices composed of such a superconducting tunnel junction element, a gate electrode is formed between the oxide superconductors via an insulation layer.

The present invention is based on the finding and utilization of a novel proximity effect exhibited by the magnetic oxide material.

Further, in the superconducting element according to the present invention, the oxide superconducting materials exhibit superconductivity in a specific temperature range and the magnetic oxide material exhibits non-superconductivity in said temperature range.

Further, laminated films having a multilayered structure of three layers or more may be formed for this purpose by alternately laminating an magnetic oxide material and an oxide superconducting material.

The superconducting elements according to the present invention represent superconductive tunnel junction elements, based on the above-mentioned proximity effect.

In practical applications of the superconducting tunnel junction elements of the invention, it is preferable that they be applied in a manner as follows.

A superconductive tunnel junction element is formed e.g. by interposing a barrier layer between oxide superconducting materials having a perovskite structure, said barrier layer being characterized by being a specific magnetic oxide material having a perovskite structure.

Hereinabove, the barrier layer refers to an intermediate layer in said three-layered structure.

Generally, the so-called perovskite structure is characterized in principle by having a crystalline structure expressed by the formula ABO₃ wherein a metal ion B is disposed at each vertex of a cube, a metal ion A is disposed in the center of gravity thereof, and oxygen atoms O are disposed with partial deficiencies in stoichiometry around the B ions. The amount of this slight oxygen deficiency influences the physical properties of the oxides having the above structure.

All of the high temperature superconducting materials hitherto are composed of copper oxides having the above crystalline structure. There are some materials in the group of non-copper oxides having perovskite structures that exhibit superconductivity characteristics at comparatively low temperatures. Hereinunder, the above group of materials is included in the oxide superconducting materials.

Among the high temperature superconducting materials there are Y₁Ba₂Cu₃O_{z}(z:6.8-7.0) which exhibit superconductivity characteristics at a superconductivity transition critical temperature (Tc) of 90 K, for example Tl₂Ba₂Ca₂Cu₃O₁₀ having a Tc of 125K.

Also, there is known (Bi,Pb)BaO₃ whose Tc is 13K.

The superconducting materials will be listed up in the following for more details:
(La₁₋ₓMₓ)Cu₂O₄ (wherein M is Ba,Ca,Sr, and x is 0.05-1.0, this relation applying also in the following),
La₁Ba₂Cu₃O₇, La₂NaCuO₄, Bi₀.₁La₁.₈Sr₀.₁CuO, La₂CuO₄,
La₂Ba₃LuCu₆O, YBa₂Cu₃O₇, Y₂Ba₄Cu₈O₂₀, Yb₂Ba₄Cu₇O₁₅,
Bi₂Sr₂CuO₆, Bi₂Sr₂Ca₁Cu₂O₈, Bi₂Sr₂Ca₂Cu₃O₁₀,
Bi₂Sr₂Ca₃Cu₄O₁₂, Ba(Pb₁₋ₓBiₓ)O₃, (Ba₁₋ₓKₓ)BiO₃, (Bi₁₋ ₓPbₓ)₂Sr₂Ca₂Cu₃O, Bi₂Sr₂.₆Nd₀.₄CuO₈, Tl₂Ba₂CuO₆,
Tl₂Ba₂Ca₁Cu₂O₈, Tl₂Ba₂Ca₂Cu₃O₁₀, Tl₁Ba₁Ca₁Cu₂O₆,
Tl₁Ba₂Ca₃Cu₄O₈, Tl₁Ba₃Ca₂Cu₄O₁₀, Tl₁Sr₂Cu₃O,
(Tl₀.₅Pb₀.₅)Sr₂Ca₂Cu₃O₈, Nd₁.₆Sr₀.₂Ce₀.₂CuO₄,
(Tl₀.₇₅,Bi₀.₂₅)₁.₃(Sr₀.₅Ca₀.₅)₂.₇Cu₂O₈,
Pb₂Sr₂Y₀.₅Ca₀.₅Cu₃O₈, TiO, NbO, LiTi₂O₄,
ABO₃ (wherein A is Li, Na, K, Rb, Cs, B is W, Mo, Re, and x is 0.8-1.0).

More particularly, in the embodiments of the present invention, the oxide superconducting materials are preferably copper oxide superconducting materials.

Further, as said barrier layer or so-called intermediate layer materials, the specific magnetic oxide materials specified above having a perovskite structure are used, in particular to contain magnetic elements such as Mn, Co, Cr, Fe, Ni, Ru and so on.

Through employment of the above-indicated magnetic oxide materials, the thickness of a film composed of the magnetic material used as a barrier layer in the above sandwich structure can exceed 100 nm.

In the superconducting tunnel junction element according to the present invention formed e.g. by interposing a barrier layer between oxide superconductors having a perovskite structure, the temperature to yield a magnetic order in said barrier layer composition material, i.e., the temperature to exhibit the so-called spontaneous magnetization therein, is characterized by being lower than the superconductivity transition critical temperature of the superconductors.

Generally speaking, magnetic substances lose their magnetic properties above certain temperatures. These temperatures differ according to the magnetic substances from extremely low temperatures to high temperatures. In magnetic oxide materials used according to the present invention, for instance, in La₁Mn₁O_{y} (where y is 2.7 to 3.3), this temperature is 141 K, and at temperatures exceeding this value the magnetic substance does not show its magnetic characteristics any more.

The present invention is closely related to the magnetic characteristics in the magnetic oxide materials as hereinabove described, and is based on the fact that when the temperature to yield the magnetic order is lower than the superconductivity transition critical temperature, the superconductivity characteristic of an element thus composed varies near that temperature.

When a superconducting multilayer tunnel junction element is fabricated by laminating an oxide superconductor and a magnetic oxide material alternately, spin-to-spin interactions induced therein serve to increase its critical temperature and also its critical current density in a magnetic field.

Further, with respect to the superconducting elements according to the present invention, it is preferable that they be formed by laminating an oxide superconductor and a magnetic oxide material or by interposing a magnetic oxide material between oxide superconductors, and that the magnetic oxide material has the same crystalline structure as that of the oxide superconductors.

It is still further preferable that the crystal structures of the oxide superconductors and the magnetic oxide material are grown with an epitaxial azimuth relationship.

Furthermore, it is preferable that the above superconductors and the magnetic oxide material both possess a perovskite structure, and that each layer thereof be grown with an epitaxial azimuth relationship.

These layered structures have characteristics unique to laminated thin films or oxide super lattice materials.

In accordance with a prefered embodiment of the superconducting elements according to the present invention formed by interposing a magnetic oxide material between oxide superconductors, the film thickness of the magnetic oxide material is greater than the coherence length in the direction of the c-axis of the oxide superconductors. More particularly, the film thickness is preferably as great as approximately 250 times the coherence length, that is, approximately 1.5 µm, which has been confirmed to be accomplished.

As hereinabove described, by utilizing the magnetic oxide material as the intermediate layer, and through the novel superconductive proximity effect exhibited by the magnetic oxide material, the superconduction wave function thereof is capable of effecting interactions over a long distance far exceeding its coherence length.

In accordance with a prefered embodiment of the superconducting element of the present invention utilizing this proximity effect, a pair of electrodes is disposed facing each other via a gap portion on a magnetic oxide material which has been formed on a substrate.

When this element is irradiated with electromagnetic waves, a superconducting current flowing through the element turns to assume the voltage state, which phenomenon may be utilized for detecting electromagnetic waves.

The above-mentioned substrate may be a single crystal substrate of a magnetic oxide material, and on the surface of this substrate a pair of superconducting electrodes may be disposed.

In this superconducting element of the present invention utilizing the proximity effect a pair of superconducting electrodes are provided disposed oppositely via a gap portion formed on a magnetic oxide material; in this case, a superconducting current flows across the above electrodes below the transitional temperature of the superconductor which constitutes the above electrodes, which is effected by the overlapping of seeped wave functions penetrating into the above magnetic oxide material.

Further, the superconducting elements according to the present may be used in arithmetic systems for performing logical operations; these systems comprise a plurality of superconducting elements each comprising a gate electrode disposed, via an insulation layer made of non-magnetic substance having a perovskite structure, between a pair of superconducting electrodes formed on a magnetic oxide material.

The superconducting devices according to the present invention are characterized by integrating a plurality of superconducting proximity effect elements having the above pair of superconducting electrodes, and having an interference prevention layer composed of a non-magnetic insulation material, disposed between the above elements.

By means of such an arrangement as above, the mutual interference of superconducting currents between adjacent elements having the respective functions can be prevented.

Further, these superconducting tunnel junction elements or superconducting proximity effect elements are preferably formed by a fabrication method of fabricating oxide super lattice materials.

More specifically, targets composed of the respective elements or their compounds provided to constitute an oxide super lattice are subjected to an ion beam injection in a specific sequence corresponding to a desired sputtering deposition cycle. It is also preferable to facilitate the fabrication of the oxide multilayer structure by concurrently supplying lower energy oxygen ions from another ion source.

More preferably, the oxygen ion energy should be below 25 eV.

The fabrication of the elements is facilitated in the case of superconducting elements having oxide superconducting electrodes disposed oppositely on a magnetic oxide material having a perovskite structure because of the extended penetrating distance for a superconduction wave function.

Further, through application of the above superconducting proximity effect element, a high speed switching operation can be accomplished. Hereby, use is made of the phenomenon that a superconduction current flows across a pair of superconducting electrodes at temperatures below the superconductivity transistion temperatures because each superconduction wave function penetrating the magnetic oxide material from respective sides of the superconducting electrodes overlaps therein. A voltage is applied across the pair of superconducting electrodes to control the superconduction current, thereby providing a switching operation.

Further, through application of the above-mentioned superconducting proximity effect element, a high precision light detection can be accomplished.

This also makes use of the fact that below the superconductivity transition temperatures, each wave function penetrating the magnetic oxide material formed between a pair of superconducting electrodes from both ends overlaps therein permitting a superconduction current to flow across the pair of superconducting electrodes. More specifically, the detection of light is accomplished by detecting the change in the superconduction current flowing between photoreceptor portions at both electrodes, while light is irradiated on a hole supplier layer provided between the pair of superconducting electrodes.

With respect to such superconducting devices, the degree of occurrence of the proximity effect therein can be controlled by irradiating light, i.e., electromagnetic waves, or by varying the applied electric field, the applied magnetic field, the temperature, the pressure or the like so as to effect the superconducting devices to perform switching operations.

The inventors of the present invention have discovered the novel phenomenon that superconducting electron pairs seep or penetrate over a long distance into magnetic oxide materials having a perovskite structure.

This penetration or seepage effect is similar to the phenomenon known as so-called proximity effect which is manifested in the lamination structure of Nb superconductors and Si semiconductors wherein superconducting electron pairs penetrate from the superconductor into the semiconductor permitting a portion of the semiconductor to assume the properties of the superconductor.

That is, the properties of the superconductors which penetrate into a three-layered structure from the upper superconductor and the lower superconductor into a thick non-superconducting layer, overlap therein permitting a superconduction current to flow therethrough.

The inventors of the present invention have succeeded in the fabrication of three-layered junctions which yield such features as above by employing magnetic oxide materials having a perovskite structure as a barrier layer. This has been effected by the same electron structure in the magnetic oxide materials as that in the oxide superconductors.

Further, that the superconducting electron pairs are permitted to seep readily, and that the magnetic spin order in the magnetic substance retains electron pairs stably are considered to play important roles in this effect.

The lamination film having a three-layered structure according to the present invention is regarded in principle to have been based on the novel phenomenon different from that of the prior art Josephson junction. In order to clarify these points, the junction according to the invention is called "superconducting tunnel junction".

This is because that, according to the prior art, the fabrication of Josephson junctions has been very difficult as it is necessary to form a barrier layer composed of an insulator within several Ångstrøms, with the coherence lengths of a high temperature superconductor being extremely short, i.e., approximately 10Å in the a, b-plane, and approximately 3 Å in the c-axis direction.

On the other hand, with respect to the metallic superconductors, a superconduction current is permitted to flow at temperatures below the critical temperatures from an upper superconductor layer to a lower superconductor layer in a lamination film having a three-layered structure with an insulator of several tens of Ångstroms in thickness being interposed between the superconductors. However, there arises no voltage therebetween.

This conduction of superconduction current occurs by means of the so-called Josephson effect whereby superconducting electron pairs are permitted to pass through a thin insulator or barrier layer by tunneling. Also, this three-layered lamination structure is called Josephson junction.

According to the present invention, a junction structure exhibiting the above-mentioned properties has been successfully fabricated using copper-series oxide super-conductors capable of showing high temperature superconductivity, in spite of the fact that, in comparison with metallic superconductors, the copper-series oxide superconductors have an extremely short coherence length only within which the superconducting electron pairs are permitted to retain a correlation. The junction thus fabricated has opened a new application field relating to faster operating switching elements. The unit lattice in copper-series oxide superconductors consists of a plurality of perovskite structures stacked up in the c-axis direction, with a lattice constant of approximately 3.8 Å in the a, b-plane, and of approximately 12 Å in the c-axis direction.

The coherence lengths on the a,b-plane being approximately 10 Å and in the c-axis direction approximately 3 Å, the copper-series oxide superconductors have values smaller by one or two orders of magnitude than those of the prior art superconductors.

When attempting to fabricate Josephson junctions using copper-series oxide superconductors, it has been necessary according to the prior art to form an insulation layer to be provided between superconductors within a film thick-ness of several Ångstrøms, which has thus been very difficult. However, according to the present invention, the fabrication has become possible using currently available thin film fabrication techniques, permitting a film thickness in the order of approximately 70 nm which is 250 times or more as large as the coherence length available in the c-axis direction in the oxide superconductors.

Further, superconducting tunnel juction elements according to the present invention involve no problems such as to cause the critical current density to decrease drastically in a magnetic field, which is the critical current value permitting a superconducting current to flow, thereby providing a preferred material which permits to achieve a stable flowing of the current even in a magnetic field due to the spin-spin interactions between the magnetic material and the superconductor.

In the following, the invention will be further explained with reference to prefered embodiments and the accompanying drawings.
Fig.1 shows a cross-sectional view of a superconducting tunnel junction element according to the present invention.
Fig.2 shows the temperature dependency of the specific resistance in magnetic oxide films.
Fig.3 is a plan view of an element embodying the present invention.
Fig.4 shows current versus voltage characteristics for superconducting tunnel junction elements.
Fig.5 shows current versus voltage characteristics for superconducting tunnel junction elements subjected to microwave irradiation.
Fig.6 is a cross-sectional view of a further element embodying the invention.
Fig.7 shows current versus voltage characteristics for an element embodying the invention having a barrier film thickness set at 500 nm.
Fig.8 shows relationships between the critical current values (Ic) and the saturation magnetization (Ms) in the element.
Fig.9 shows current versus voltage characteristics for a specific barrier layer composition and their temperature dependency.
Fig.10 is a schematic diagram showing the temperature dependency of the junction resistance for the element of a first embodiment of the invention.
Fig.11 illustrates respective characteristics in the upper and lower superconductor layers in the element of a second embodiment of the invention, and the temperature dependency of its junction resistance.
Fig.12 illustrates a schematic diagram of a superconducting switching element.
Fig.13 shows operational characteristics of a superconducting switching element.
Fig.14 explains the switching operation of the superconducting switching element.
Fig. 15 explains the relationship between the gap length and the critical current in a superconducting switching element.
Fig.16 is a schematic diagram showing a photo detection element embodying the invention.
Fig.17 shows photo-responsive characteristics of the photodetection element.
Fig. 18 shows the specific resistance versus temperature characteristics of a multilayer superconducting tunnel junction element.
Fig.20 shows superconductivity characteristics of a multilayer superconducting tunnel junction element in magnetic fields, and
Fig.21 shows an equipment for fabricating a multilayer superconducting tunnel junction element.

### EMBODIMENT 1

This example embodying the present invention is based on the discovery made by the inventors while investigating the proximity effect in oxide superconductors that a superconduction wave function penetrates over a substantially long distance into an magnetic oxide material disposed adjacent to the oxide superconductors, which distance extends to as much as 1.0 µm.

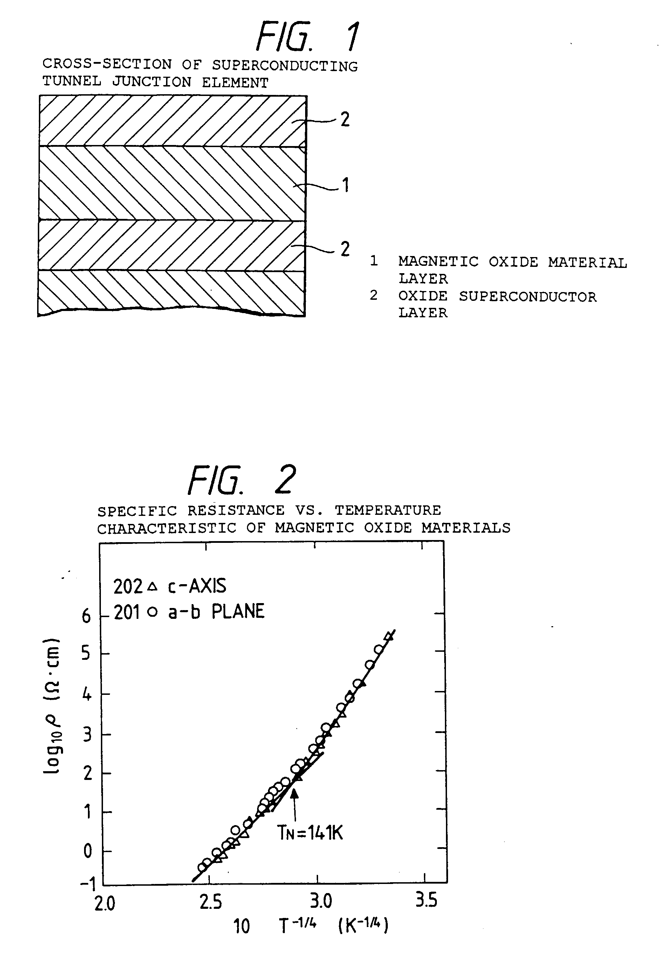

The first embodiment of the invention will be described in the following with reference to Fig.1. Fig.1 shows a three-layer structure comprising two layers composed of an oxide superconductor 2 and a film of a magnetic oxide material 1 provided therebetween.

A superconducting tunnel junction having such a three-layer structure as above has been formed on an MgO(100) single crystal substrate, and the current-voltage characteristic across its junction portion has been investigated by applying a current between the upper and lower superconductor layers.

For the oxide superconductors, Y₁Ba₂Cu₃O_{z} (where z is between 6.8 and 7.0) having a perovskite structure is used, while for the magnetic oxide material La_{0.3}Ca_{0.7}MnO_{y} and La_{0.7}Ca_{0.3}MnO_{y} are used where y is in the range from 2.7 to 3.3 having its center at 3.

The investigation has been conducted using superconducting layers of 200 nm thickness and magnetic material layers the thickness of which being varied from 20 to 100 nm. Each film has been prepared by the RF magnetron sputtering method to obtain an epitaxial film having its c-axis disposed perpendicular to its substrate plane, under the fabrication conditions as listed in Table 1.

**Table 1**

| | | |
|---|---|---|
| | YBa₂Cu₃O_{Z} | La₀.₇Ca₀.₃MnO_{y} La₀.₃Ca₀.₇MnO_{y} |
| Targets | YBa₂.₅Cu₅.₀O_{Z} | La₀.₇Ca₀.₃MnO_{y} La₀.₃Ca₀.₇MnO_{y} |
| Substrate Temp.(°C) | 650 | 630 |
| Sputtering Gas (Ar/O₂) | 15/5 | 9/1 |
| Sputtering Press. (mTorr) | 12 | 12 |
| RF Power (W) | 125 | 150 |
| Growth Rate (nm/s) | 0.07 | 0.21 |
| Film Thickness (nm) | 200 | 20,30,50,100 |

Before examining electrical properties of the actual junction portions, each electrical property specific of the respective thin films of the magnetic oxide materials has been studied using a monolayer having a film thickness of 800 nm formed on an MgO(100) single crystal substrate. The results are shown in Table 2.

**Table 2**

| | La₀.₇Ca₀.₃MnO_{y} | La₀.₃Ca₀.₇MnO_{y} |
|---|---|---|
| Resistivity (Ω·cm) | 7.8×10⁻² | 4.8×10⁻² |
| Carrier conc.(cm⁻³) | 6.9×10¹⁹ | 1.5×10¹⁹ |
| Mobility(cm²·V⁻¹·s⁻¹) | 1.2 | 8.66 |
| Type | p | p |

The magnetic oxide materials of the embodiment operated as a p-type semiconductor with carriers of holes. Further, at low temperatures below 130 K, they exhibited a magnetization of 10 to 40 emu/cm³.

On the other hand, using oxide single crystal films having a film thickness of 200 nm formed on a SrTiO₃(110) substrate, the temperature dependency of the electrical resistance has been examined as shown in Fig.2. In Fig.2, numeral 201 indicates the specific resistance in the c-axis direction, shown by circles while numeral 202 indicates the specific resistance on the a, b-plane, shown by triangles. From this diagram, it may be seen that there exists no anisotropy in the electrical conductivity, and that there arises a change in the temperature dependency at 141 K. With respect to the above-mentioned oxide material, this temperature agrees well with the Neel point, showing that this magnetic film has an antiferromagnetic spin order at temperatures below 141 K.

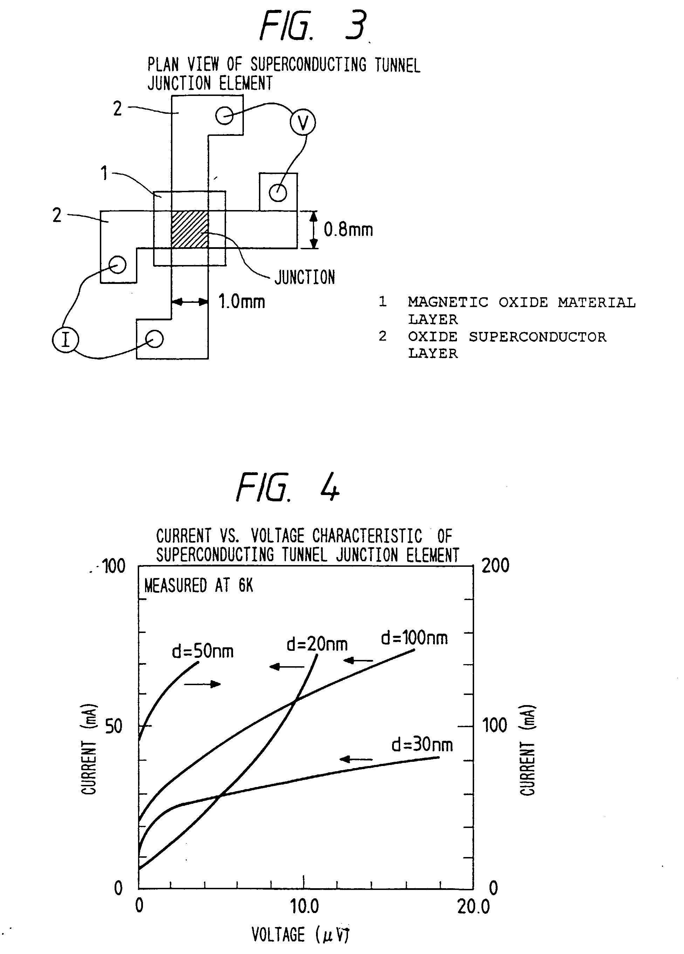

Fig.3 shows a schematic plan view of a superconducting tunnel junction element using a magnetic oxide material for its barrier. The element of Fig. 3 comprises a magnetic oxide material layer 1 and two oxide superconducting layers 2. They are formed using metal masks in the order of an oxide superconductor layer 2, a magnetic oxide material layer 1 and an oxide superconductor layer 2. In Fig.3, the hatched portion indicates the part where the superconducting tunnel junction is formed. The electrical properties of the junction connected to a current source have been measured using a voltmeter as shown in the figure. The area of the junction was 0.8×1.0 mm².

Fig.4 shows the current versus voltage characteristic of the junction measured at a temperature of 6 K. A superconducting current flowed between the upper and the lower superconducting layers in each case of film thicknesses of 20, 30, 50 and 100 nm of the barrier layer. Conduction of a superconduction current through such thick films as above would never have been accomplished according to the prior art Josephson junction, which has only been possible by utilizing magnetic oxide materials according to the invention for the barrier layer materials.

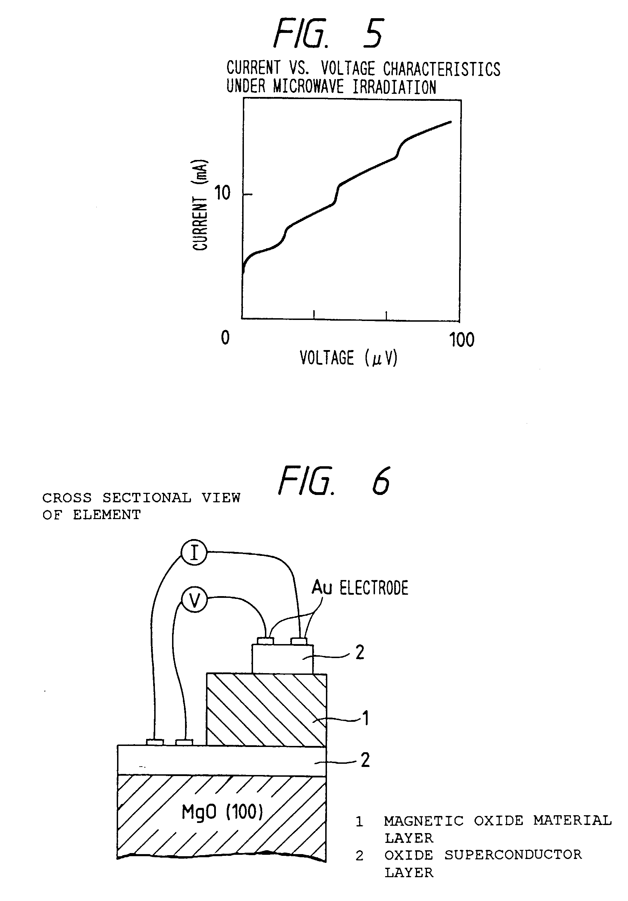

Fig.5 shows the current versus voltage characteristic of the element under irradiation of microwaves of 10 GHz at a temperature of 10 K. Responding to the microwaves, the element has demonstrated definite stepwise changes in the current versus voltage characteristic. According to the present invention, the fabrication of superconducting tunnel junctions capable of responding to microwaves has been implemented.

As has been set forth in this embodiment, the superconducting tunnel junction element embodying the invention has been provided through utilization of the novel proximity effect discovered to exist between a high temperature superconductor or so-called oxide superconductor and a magnetic oxide material.

Further, a lattice matching problem between the barrier layer material and the superconductors has been eliminated by application of the above effect, thereby providing a novel barrier material having an excellent lattice matching with no reactivity therebetween suitable for providing a preferable superconducting element.

By further improving the embodiment of the invention, a method of fabricating the superconducting proximity effect elements using oxide superconductors has been accomplished.

Still further, through accomplishment of the proximity effect element using oxide superconductors, a superconducting electromagnetic wave detection element of the proximity effect type has been provided.

Furthermore, on the basis of the novel phenomenon of the invention and using thus obtained oxide superconductors, the inventors have been able to fabricate a superconducting transistor, a high frequency mixer, a fast operating switching element, and a high sensitivity detection element for electromagnetic waves.

By fabricating a superconducting device using a magnetic oxide material as a semiconductor substrate, a superconducting transistor causing no reaction between its superconductors and the substrate can be achieved.

With respect to the prior art, it has been regarded that the penetration distance for a wave function into a semiconductor was short corresponding to a short coherence length of approximately 3 to 4 Å in the c-axis direction, and that the gap length between the electrodes consisting of superconductors was less than 100 Å. In contrast to the above, by employing the present embodiment of the invention, the gap length between the superconducting electrodes has been substantially increased, up to approximately 5000 Å or more. Thereby, superconducting proximity effect elements applicable such as for superconducting transistors and the like have been fabricated.

Further, superconducting devices using oxide superconductors capable of being operated at liquid nitrogen temperatures have been provided.

### EMBODIMENT 2

Another embodiment of the present invention has been fabricated using oxide superconductors as superconducting layers and magnetic oxide materials as barrier layers, all materials being identical to those utilized in the first embodiment, but formed into a superconducting tunnel junction having a different shape from the first embodiment, and their characteristics have been investigated.

Fig.6 shows a cross-section of an element embodying the present invention. The element of Fig.6 comprises a magnetic oxide material layer 1 and two oxide superconductor layers 2. Each layer is formed with its c-axis disposed perpendicular to the substrate plane on an MgO (100) single crystal substrate. The film thickness of the oxide superconductor layers was set at 200 nm, and that of the magnetic oxide material layer was set at 200 and 500 nm.

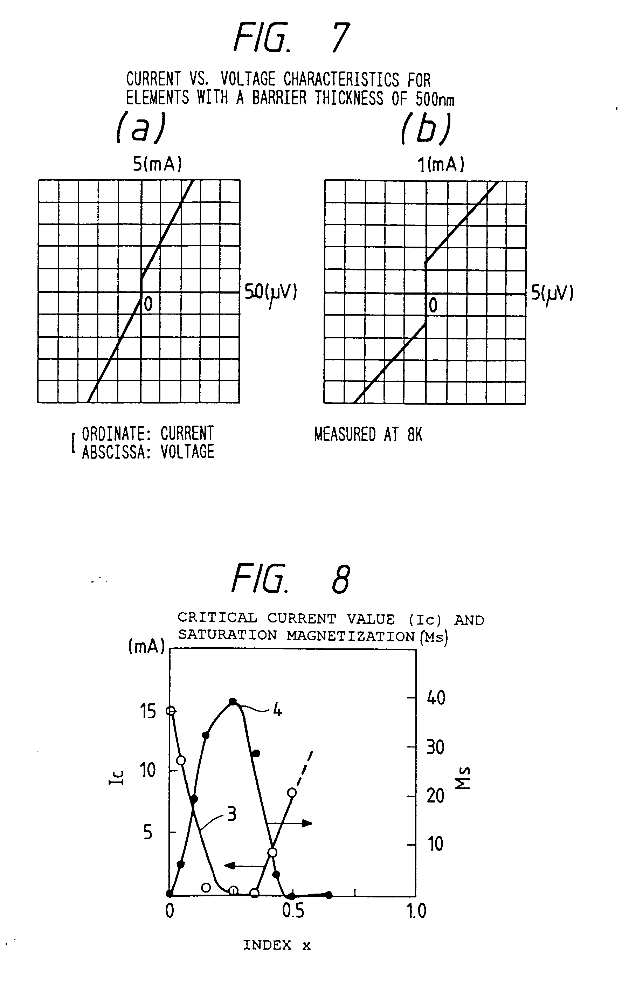

Fig.7 shows the current versus voltage characteristics of the superconducting tunnel junction having a barrier layer thickness of 500 nm measured at a temperature of 8 K. (a) and (b) in Fig.7 show the same results on different scales.

It has been found that a superconducting current flows through a magnetic oxide material layer being an extremely thick film. Further, it has been confirmed that, when the film thickness was further increased, approximately up to 2 pm, the superconducting current did not flow. This novel phenomenon has been discovered by the inventors of the present invention for the first time that the superconducting current flows through a non-superconductor having such a large film thickness. Thereby, there have been solved problems such as reactivity arising at the interface between laminated thin films, or inability to form a barrier layer having a film thickness of more than several Ångstrøms which is restricted due to the short coherence length of the oxide superconductors; hence, superconducting tunnel junctions which could never be fabricated by the prior art, have been provided.

This has been effected by utilizing magnetic oxide materials having a perovskite structure as a barrier layer, and the spin correlation in the oxide substances as well as their electrical conduction mechanism on the basis of hopping conduction are regarded to have played important roles.

### EMBODIMENT 3

Another preferred embodiment of the present invention will be set forth which utilizes an magnetic oxide material (La,Sr)₁Mn₁O_{y} having a perovskite structure as a barrier layer.

The thickness of the barrier layer thin film was set at 200 nm, and a similar element identical to the embodiment 1 was fabricated. The magnetic oxide material did show antiferromagnetism for x = 0 in the compositions La₁₋ₓSrₓMn₁O_{y}, while it assumed ferromagnetism with an increasing value of x. It showed a maximum value of ferromagnetism for x= 0.3. It, however, assumed antiferromagnetism again when x exceeded 0.5.

Fig.8 shows the result of the investigation how the critical current values of the superconducting current would change relative to the values of x in the compositions.

The measurements were done at the temperature of 6 K. In Fig.8, curve 3 indicates the critical current values (Ic), and curve 4 indicates the saturation magnetization (Ms) of the magnetic substances at room temperature. The magnitude of the saturation magnetization represents the degree of intensity of the ferromagnetism of the magnetic oxide materials.

With the onset of ferromagnetism, the superconduction current stops to flow, and it has been found that while in the magnetic oxide materials having antiferromagnetic spin orders the superconducting electron pairs remain stable, the electron pairs in the magnetic oxide materials having ferromagnetic spin orders would be broken.

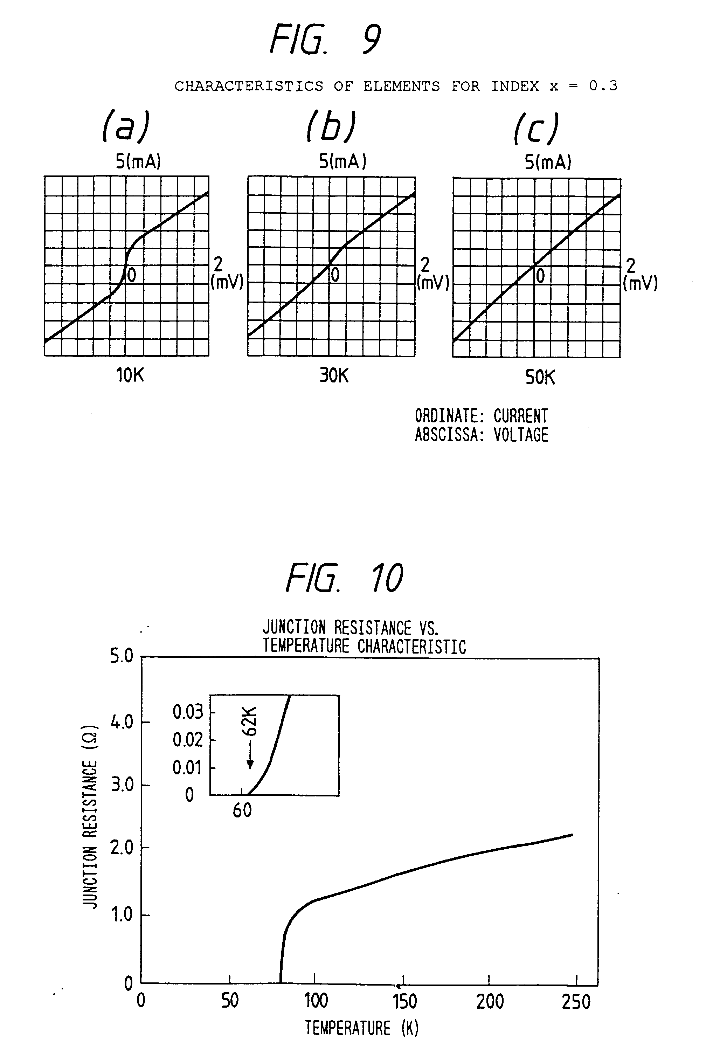

Fig.9 shows the temperature dependencies of the current vs. voltage characteristics of elements having, as their barriers, magnetic oxide materials having the compositions indicating the maximum ferromagnetism at x = 0.3. In Fig.9, (a), (b) and (c) show the results obtained at 10 K, 30 K and 50 K, respectively. As shown in Fig.9 (a), the current vs. voltage characteristic of the current flowing through a junction has a non-linear bend, indicating that the current is of quasiparticle type and that there exist interactions between the upper and lower superconducting layers. Even through a magnetic layer as thick as 200 nm, there exist interactions between the upper and lower superconductors, indicating that there exists a proximity effect taking place through a long distance. The bend in the curve tends to disappear with increasing temperature to become a straight line as shown in Figs.9 (b) and (c). These elements having such characteristics have shown the same response to electromagnetic waves identical to the case of Fig.5.

### EMBODIMENT 4

An element identical to the embodiment 1 has been fabricated utilizing magnetic oxide materials having various magnetic properties, with a barrier layer film thickness of 200 nm.

Current vs. voltage characteristics at a temperature of 9 K have been investigated, and non-linearities in the characteristics or tunnelling properties of the current flowing between the upper and lower superconductors have been examined. The results are summarized in Table 3.

**Table 3**

| Magnetic and Tunnelling Properties of Barrier Layers | | |
|---|---|---|
| Magnetic Property | Tunnelling Property | Interactions between Upper and Lower Superconductors |
| Ferromagnetic | Quasi-particle | exist |
| Antiferromagnetic | Superconducting Current | exist |

When magnetic oxide materials having a perovskite structure and antiferromagnetic spin order are used as a barrier layer material, there occurs a penetration of electron pairs over a long distance with the electron pairs maintained stably, thereby permitting a superconduction current to flow between the upper and the lower superconductors.

On the other hand, when magnetic oxide materials having ferromagnetic spin order are used, the current vs. voltage characteristics exhibit a quasiparticle type, whereby the ferromagnetic property breaks up the electron pairs, but there still exists a long distance interaction.

From the above findings, it has been found that an electric conduction mechanism based on the hopping type conduction in the magnetic oxide materials used as the barrier layer according to the present invention plays an important role in the novel long-range proximity effect discovered by the inventors, permitting the superconducting electron pairs to penetrate in an extremely stable manner when an antiferromagnetic spin order exists.

### EMBODIMENT 5

The temperature dependency of the junction resistance of a superconducting tunnel junction similar to the embodiment 1 is shown in Fig.10, wherein the barrier layer film thickness was set at 100 nm, and La_{0.7}Ca_{0.3}MnO_{y} was utilized for the magnetic oxide material.

Whereas its specific resistance indicates a semiconductor property as shown in Fig.2, its junction resistance decreases like with metals, which indicates that an interaction exists even in a normal conduction state between the superconducting layers.

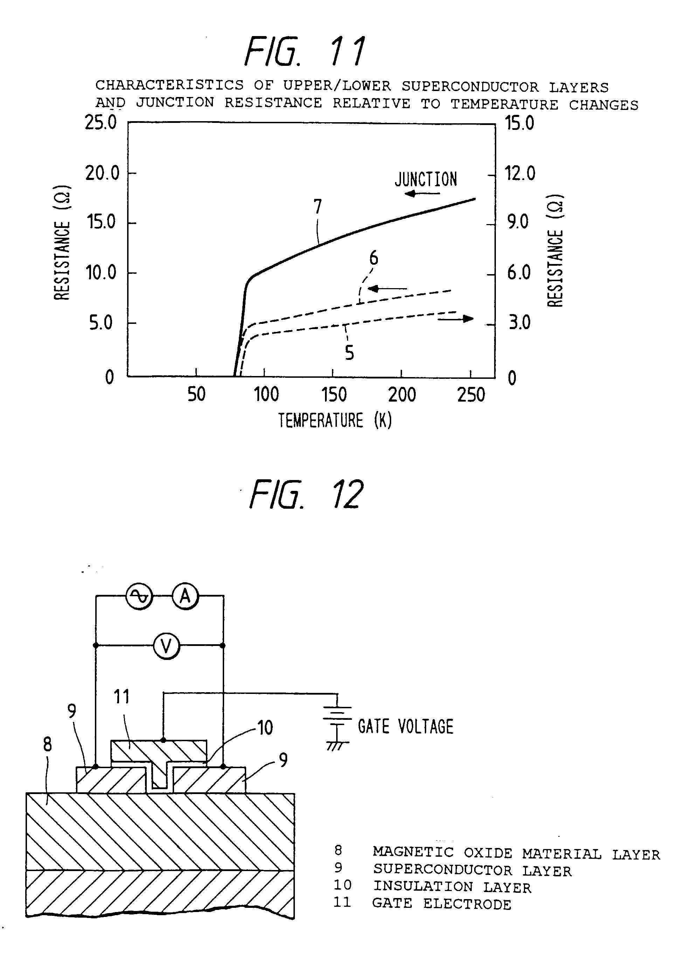

The characteristics for an element similar to the embodiment 2 are shown in Fig.11, wherein the barrier layer film thickness was set at 500 nm. In Fig.11, curve 7 indicates the temperature dependence of the junction resistance, and curves 5 and 6 show the respective superconduction characteristics for the upper and the lower superconductors. It may be seen that both the upper and the lower superconductors exhibit a superconductivity state at temperatures below 80 K.

It may also be seen that the junction resistance decreases with decreasing temperature in a metallic mode all the same.

### EMBODIMENT 6

The magnetic element Mn in La₁Mn₁O_{y} in one of the oxide magnetic substances which exhibit antiferromagnetism has been replaced by a non-magnetic element and diluted. A superconducting tunnel junction of another embodiment of the invention has been fabricated by lamination with Y-series superconductors, with the temperature for yielding a magnetic order to be at 50 K, and utilizing a barrier layer having a film thickness of 200 nm.

Both the upper and the lower superconductor layers used exhibited superconduction characteristics at 80 K. At temperatures between 50 K and 80 K in this case, whereas there have been observed non-linearities in the current vs. voltage characteristics, no superconduction currents did flow.

However, at temperatures below 50 K where a magnetic order has appeared in the magnetic layer, a superconduction current is effected to flow. When Mn was completely replaced by a non-magnetic element, there have not been observed non-linearity nor superconduction currents, which shows that the antiferromagnetic orders in the magnetic oxide materials have an important effect on the implementation of the present invention.

The same phenomenon has been observed in the proximity effect element according to the present invention. In either cases of the superconducting tunnel junction element and superconducting proximity effect element, there has been found a penetration of electron pairs to take place over a long distance due to the same mechanism as hereinabove set forth.

### EMBODIMENT 7

Still another embodiment of the present invention will be set forth with reference to Fig.12. Fig.12 illustrates a schematic view of a superconducting switching element according to the invention. The element of Fig.12 comprises a substrate 8 made of a magnetic oxide single crystal material, on which a pair of superconducting electrodes 9 made of an oxide superconductor, disposed opposite to each other via a gap, are formed, and a gate electrode 11 is formed therebetween via an insulation layer 10.

At this time, an antiferromagnetic material, Bi₁Mn₁O_{y}, has been employed as magnetic oxide material, and a non-magnetic oxide LaGaO₃ or LaAlO₃ having the same perovskite structure as the magnetic oxide material and the oxide superconductors has been utilized as the insulation layer at the gate portion.

The distance between the superconducting electrodes 9 is set at 1.8 µm. As shown in this figure, a current source and a voltmeter are connected between the pair of superconducting electrodes to examine the electrical properties of the element.

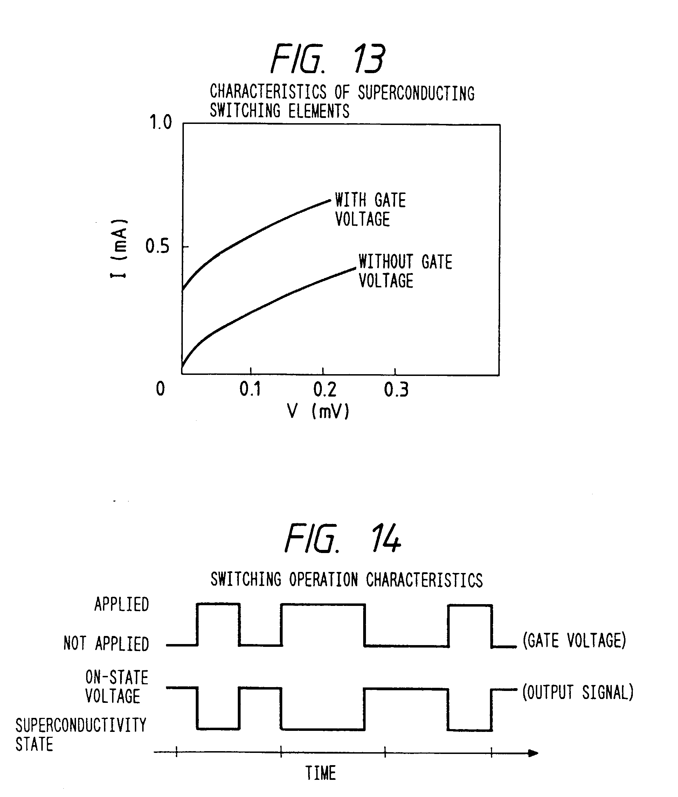

Fig.13 shows the current vs. voltage characteristics measured between the superconducting electrodes at 77 K. The figure shows that the value of the superconducting current flowing between the superconducting electrodes increases when a gate voltage is applied.

Switching operation characteristics based on the above-mentioned characteristics are shown in Fig.14. Corresponding to the on-off state of the gate voltage, a superconductivity state (0) or a voltage state (1) is obtained.

It has further been examined how the value of the critical current for a superconduction current will change, when the gap width between the superconducting electrodes is changed in an element having a structure as shown in Fig.12.

A superconduction current has been found to flow between the electrodes for gap widths up to 1.5 µm, which currents are permitted to flow due to the overlapping of the superconductivity penetration effected between the oppositely disposed superconducting electrodes over a long distance that has never been described before in the prior art.

### EMBODIMENT 8

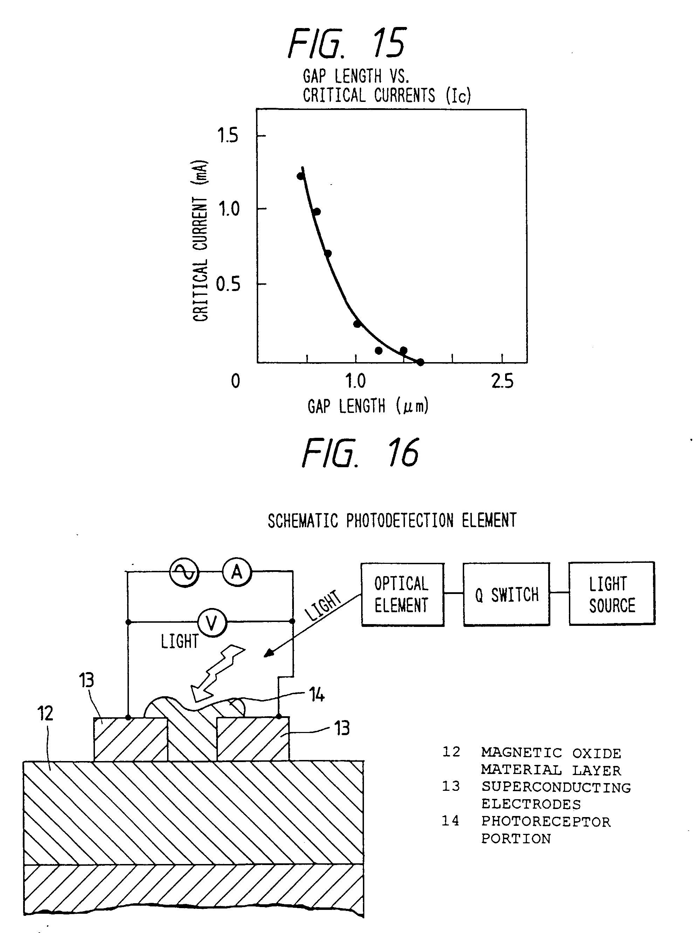

Still another embodiment of the invention will be described in the following with reference to Fig.16.

An element having the same structure as the embodiment 7 of the invention has been fabricated. The element shown in Fig.16 comprises a magnetic oxide material 12, La₀.₇Ca₀.₃MnO_{y}, at the right and left hand sides on the surface of which are formed superconducting electrodes 13. Between the superconducting electrodes 13 is formed a photoreceptor portion 14 utilizing a p-type amorphous silicon film.

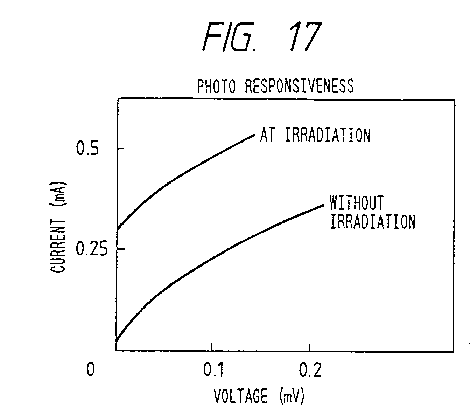

A current flows from one of the superconducting electrodes to the other in the element so that the voltage between the superconducting electrodes 13 may be monitored in a manner as shown in Fig.16. With this arrangement, the above-mentioned photoreceptor portion 14 was irradiated with laser light having a wavelength of 5145 Å. The results are shown in Fig.17. When irradiated with the light, the likelihood of taking place of the proximity effect due to a carrier diffusion from a hole supplier layer increases, thereby enabling to increase the superconduction current, and thus demonstrating a responsiveness to light.

Further, the high speed response characteristics of this photodetection element have been examined by generating in repetition an extremely short pulse light having a pulse width of 2 ns and applying it through an optical system via Q-switching of light from a light source. The element is found to respond to these pulses without delay. As the result of a similar experiment conducted on logic circuits fabricated using these elements, it is found that the switching speed per individual element is less than 1 ps.

In view of the observation that the value of the superconduction current changed in response to the irradiation of light, applications as photo detection elements or light switching elements are possible.

### EMBODIMENT 9

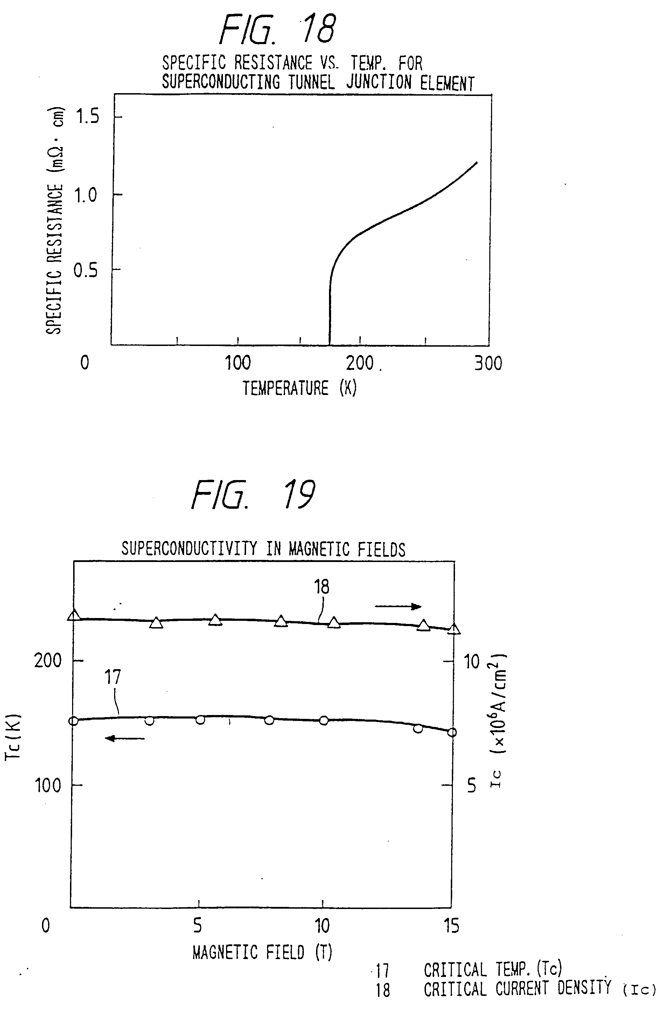

Fig.18 shows the specific resistance vs. temperature characteristic of superconducting multilayer tunnel junction element using La₁Mn₁O_{y} having a perovskite structure as magnetic oxide materials, and using Tl₂Ba₂Ca₂Cu₃O₁₀ having a perovskite structure as oxide superconductors.

The film thickness of the magnetic layers was set at 150 nm, and that of the superconductor layers was set at 100 nm. The critical temperature (Tc) for the oxide superconductors is generally at 125 K, but the oxide super lattice material according to the present invention showed its superconductivity transition at 175 K. This has been effected by the action of the antiferromagnetic spin order in the magnetic oxide material layer.

Fig.19 shows the superconductivity characteristics in magnetic fields. Tc indicated by numeral 17 for the multilayer tunnel junction element has shown hardly any decrease under magnetic fields as becomes evident from the figure, and also its critical current density indicated by numeral 18 has shown no substantial decrease in magnetic fields up to 15 T.

### EMBODIMENT 10

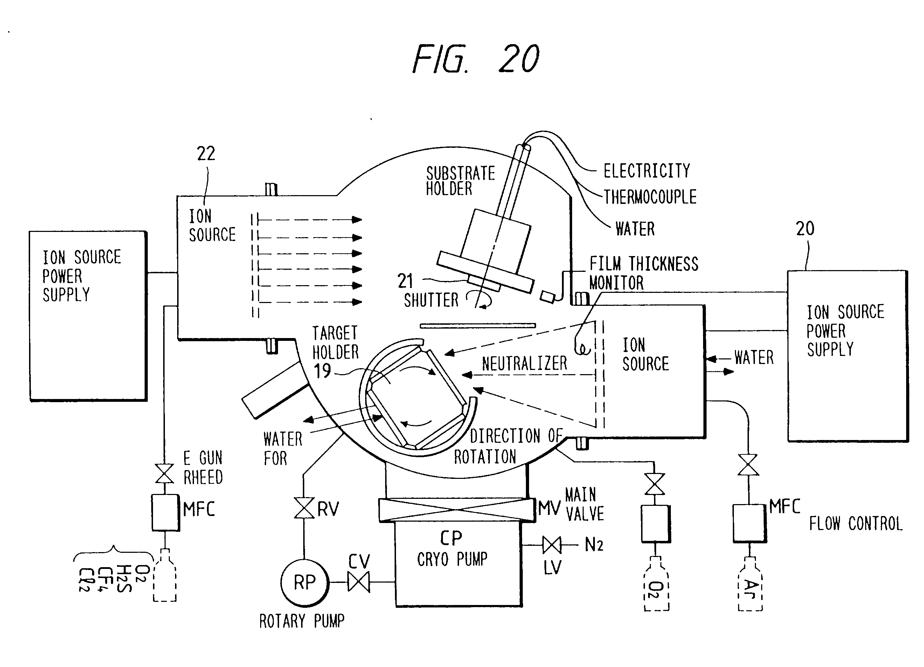

A method of fabricating the superconducting multilayer tunnel junction element according to the present invention using a fabrication equipment as shown in Fig.20, and examples of its fabrication equipment will be described in the following.

This equipment is characterized by comprising two ion sources: an ion source 20 for sputtering atoms to constitute a target on a target holder 19 through ion beam implantation, and another ion source 22 capable of irradiating a substrate on a substrate holder 21 with low energy ion beams.

The magnetic oxide materials and the oxide superconductors are laminated alternately utilizing this fabrication equipment.

In this preferred embodiment of the invention, as a magnetic oxide material, SrCoO_{y} (y: in the range from 2.8 to 3.3) having a perovskite structure was utilized, and as an oxide superconductor, Bi₂Sr₂Ca₂Cu₃O₁₀ was utilized.

The respective film thicknesses were set at 200 nm and 100 nm. During the fabrication of lamination films, the films were deposited alternately under irradiation of an oxygen ion beam.

In case the energy of the oxygen ion beam irradiated exceeded 50 eV, all of the oxide superconductors and the magnetic oxide materials were damaged by the kinetic energy of the ions, resulting in defective crystal properties.

In contrast to the above, when the films were fabricated under irradiation of a low energy ion beam of 25 eV, both the crystal and superconductivity properties have been improved.

A film of an oxide superconductor monolayer prepared under irradiation of an ion beam was compared with a film prepared without the ion beam irradiation, and it was revealed that the half-value width of the former at X-ray diffraction changed from 0.8 to 0.1 degrees, and its critical temperature increased from 60 K to 100 K.

The observation of the lamination structure according to the present invention with the transmission electron microscope revealed that an excellent epitaxial growth has been obtained for each lamination.

Further, its critical temperature was increased to 120 K, which is higher than the critical temperature for the oxide superconductor monolayer.

According to the present invention, it is no longer necessary to fabricate a barrier layer into an extremely thin film of less than several Angstroms, thereby facilitating the fabrication of superconducting elements utilizing oxide superconductors.

Further, according to the present invention, a semiconductor layer material is provided which does not react with a superconducting electrode composed of an oxide superconductor, thereby facilitating the fabrication of superconducting proximity effect elements utilizing oxide superconductors.

Still more, according to the present invention, a semi-conductor layer material can be provided which does not react with superconducting electrodes composed of an oxide superconductor, and provides a good lattice matching, thereby enabling fabrication of excellent superconducting proximity effect elements.

Furthermore, according to the present invention, the gap length between superconducting electrodes can be extended to as much as approximately 1.5 µm, thereby facilitating its fabrication, and enabling the fabrication of superconducting proximity effect elements utilizing oxide superconductors.

Further, according to the present invention, electromagnetic wave detection elements can be fabricated utilizing an oxide superconductor, thereby enabling to improve its detection sensitivity and provide a faster operational speed.

Still further, according to the present invention, superconducting proximity effect elements can be fabricated utilizing an oxide superconductor, thereby providing a faster switching function.

Further, according to the present invention, superconducting multilayer tunnel junction elements can be provided which have a critical temperature higher than 160 K, which could never be obtained in the prior art, and wherein the critical current density does not decrease even in magnetic fields.

## Claims

1. Superconducting tunnel junction element comprising a non-superconductive magnetic oxide material (1; 8; 12) having two junction interfaces to oxide superconductors (2; 9; 13),
the magnetic oxide material having a perovskite structure,
characterized in that
the magnetic oxide material (1; 8; 12) is one of the following materials:
(La, Ca)₁Mn₁O_{y},
(La, Sr)₁Mn₁O_{y},
(La, A)₁B₁O_{y} (where A is at least more than one species of alkaline earth elements; B is at least one of Mn, Co, Fe and Ni),
Bi₁Mn₁O_{y},
Ba₁Fe₁O_{y},
Sr₁Co₁O_{y},
(La, A)₁B₁O_{y} (where A = Ba, Sr, Pb, Cd; B = Mn, Co),
[(Pr, Nd), (Ba, Sr)]₁Mn₁O_{y},
(Bi, Ca)₁Mn₁O_{y},
La₁(M, Mn)₁O_{y} (where M = Co, Ni, Cu, Cr),
Gd₁(Co, Mn)₁O_{y},
A₁(Fe, B)₁O_{y} (where A = Ba, Ca, Sr; B = Mo, Mn),
Bi₁Cr₁O_{y},
Ca₁Ru₁O_{y},
A₁(B, C)₁O_{y} (where A = Ba, Ca, Sr, Pb; B = Ni, Mn, Cr, Fe; C = W, Sb, Mo, U),
(Sr, La)₁(C, D)₁O_{y} (where C = Co, Ni; D = Nb, Sb, Ta),
y being from 2.7 to 3.3.

2. Superconducting tunnel junction element according to claim 1, composed of oxide superconductors (2) and a magnetic oxide material (1) which is interposed therebetween.

3. Superconducting tunnel junction element according to claim 1, composed of oxide superconductors (9; 13) formed on the surface of a magnetic oxide material (8, 12) between which is a gap structure.

4. Superconducting tunnel junction element according to claim 2, wherein the film thickness of the magnetic oxide material (1) is larger than the coherence length in the c-axial direction of the oxide superconductors.

5. Superconducting tunnel junction element according to claim 2 or 4, characterized in that both the magnetic oxide material (1) and the oxide superconductors (2) having the same crystal structure have been grown in an epitaxial azimuth relationship.

6. Superconducting device composed of a superconducting tunnel junction element according to claim 3 and a gate electrode (11) formed between the oxide superconductors (9; 13) via an insulation layer (10).

7. Integrated superconducting device composed of a plurality of superconducting tunnel junction elements according to claim 3, wherein an interference prevention layer composed of a non-magnetic and insulating material is disposed between the elements.

8. Photodetection element composed of a superconducting tunnel junction element according to claim 3 and a photoreceptor portion (14) formed therebetween.

9. Use of the superconducting tunnel junction elements according to claim 3 or 8 for detecting electromagnetic waves.

10. Use of a plurality of superconducting devices according to claim 6 in arithmetic systems for performing logical operations.

## Patentansprüche

1. Supraleitendes Tunnelübergangselement, das ein nicht supraleitendes magnetisches Oxidmaterial (1; 8; 12) aufweist, das zwei Grenzflächen zu Oxid-Supraleitern (2; 9; 13) besitzt,
wobei das magnetische Oxidmaterial eine Perovskit-Struktur aufweist,
dadurch gekennzeichnet, daß
das magnetische Oxidmaterial (1; 8; 12) eines der nachstehenden Materialien ist:
(La, Ca)₁Mn₁O_{y},
(La, Sr)₁Mn₁O_{y},
(La, A)₁B₁O_{y} (wobei A mindestens mehr als ein Erdalkalimetall und B mindestens ein unter Mn, Co, Fe und Ni ausgewähltes Metall bedeuten),
Bi₁Mn₁O_{y},
Ba₁Fe₁O_{y},
Sr₁Co₁O_{y},
(La, A)₁B₁O_{y} (wobei A = Ba, Sr, Pb, Cd; B = Mn, Co), [(Pr, Nd), (Ba, Sr)]₁Mn₁O_{y},
(Bi, Ca)₁Mn₁O_{y},
La₁(M, Mn)₁O_{y} (wobei M = Co, Ni, Cu, Cr),
Gd₁(Co, Mn)₁O_{y},
A₁(Fe, B)₁O_{y} (wobei A = Ba, Ca, Sr; B = Mo, Mn),
Bi₁Cr₁O_{y},
Ca₁Ru₁O_{y},
A₁(B, C)₁O_{y} (wobei A = Ba, Ca, Sr, Pb; B = Ni, Mn, Cr, Fe; C = W, Sb, Mo, U), (Sr, La)₁(C, D)₁O_{y} (wobei C = Co, Ni; D = Nb, Sb, Ta), wobei y im Bereich von 2,7 bis 3,3 liegt.

2. Supraleitendes Tunnelübergangselement nach Anspruch 1, das aus Oxid-Supraleitern (2) und einem dazwischen angeordneten magnetischen Oxidmaterial (1) besteht.

3. Supraleitendes Tunnelübergangselement nach Anspruch 1, das aus Oxid-Supraleitern (9; 13) besteht, die auf der Oberfläche eines magnetischen Oxidmaterials (8; 12) ausgebildet sind und zwischen denen sich eine Zwischenraumstruktur befindet.

4. Supraleitendes Tunnelübergangselement nach Anspruch 2, bei dem die Schichtdicke des magnetischen Oxidmaterials (1) größer ist als die Kohärenzlänge in Richtung der c-Achse des Oxid-Supraleiters.

5. Supraleitendes Tunnelübergangselement nach Anspruch 2 oder 4, dadurch gekennzeichnet, daß das magnetische Oxidmaterial (1) und die Oxid-Supraleiter (2) die gleiche Kristallstruktur aufweisen und durch epitaxiales Aufwachsen in einer Epitaxie-Azimutbeziehung erzeugt sind.

6. Supraleitende Vorrichtung, die aus einem supraleitenden Tunnelübergangselement nach Anspruch 3 sowie einer Gateelektrode (11) besteht, die zwischen den Oxid-Supraleitern (9; 13) unter Zwischenschaltung einer Isolierschicht (10) erzeugt ist.

7. Integrierte supraleitende Vorrichtung, die aus mehreren supraleitenden Tunnelübergangselementen nach Anspruch 3 besteht und bei der zwischen den Tunnelübergangselementen eine aus einem nichtmagnetischen, isolierenden Material bestehende Interferenzverhinderungsschicht vorgesehen ist.

8. Photodetektorelement, das aus einem supraleitenden Tunnelübergangselement nach Anspruch 3 und einem im Zwischenraum erzeugten Photorezeptorbereich (14) besteht.

9. Verwendung der supraleitenden Tunnelübergangselemente nach Anspruch 3 oder 8 zur Erfassung elektromagnetischer Wellen.

10. Verwendung mehrerer supraleitender Vorrichtungen nach Anspruch 6 in arithmetischen Systemen zur Durchführung von logischen Operationen.

## Revendications

1. Elément de jonction à tunnel supraconducteur comprenant :
un matériau en oxyde magnétique non supraconducteur (1 ; 8; 12) comportant deux interfaces de jonction avec des supraconducteurs du type oxyde (2 ; 9; 13),
le matériau en oxyde magnétique ayant une structure de perovskite,
caractérisé en ce que :
le matériau en oxyde magnétique (1 ; 8 ; 12) est un matériau parmi les matériaux suivants :
(La, Ca)₁Mn₁O_{y},
(La, Sr)₁Mn₁Oy,
(La, A)₁B₁O_{y} (dans laquelle A est au moins plus d'une espèce des éléments alcalino-terreux ; B est au moins un élément parmi Mn, Co, Fe et Ni),
Bi₁Mn₁O_{y},
Ba₁Fe₁O_{y},
Sr₁Co₁O_{y},
(La, A)₁B₁O_{y} (dans laquelle A = Ba, Sr, Pb, Cd ; B = Mn, Co),
[(Pr, Nd), (Ba, Sr)]₁Mn₁O_{y},
(Bi, Ca)₁Mn₁O_{y},
La₁(M, Mn)₁O_{y} (dans laquelle M = Co, Ni, Cu, Cr),
Gd₁(CO, Mn)₁O_{y},
A₁(Fe, B)₁O_{y} (dans laquelle A = Ba, Ca, Sr ; B = Mo, Mn),
Bi₁Cr₁O_{y},
Ca₁Ru₁O_{y},
A₁(B, C)₁O_{y} (dans laquelle A = Ba, Ca, Sr, Pb ; B = Ni, Mn, Cr, Fe ; C = W, Sb, Mo, U),
(Sr, La)₁(C, D)₁O_{y} (dans laquelle C = Co, Ni ; D = Nb, Sb, Ta),
y étant compris entre 2,7 et 3,3.

2. Elément de jonction à tunnel supraconducteur selon la revendication 1, composé de supraconducteurs du type oxyde (2) et d'un matériau en oxyde magnétique (1) qui est interposé entre eux.

3. Elément de jonction à tunnel supraconducteur selon la revendication 1, composé de supraconducteurs du type oxyde (9 ; 13) formés sur la surface d'un matériau en oxyde magnétique (8 ; 12), une structure d'espace étant présente entre eux.

4. Elément de jonction à tunnel supraconducteur selon la revendication 2, dans lequel l'épaisseur de film du matériau en oxyde magnétique (1) est supérieure à la longueur de cohérence dans la direction axiale c des supraconducteurs du type oxyde.

5. Elément de jonction à tunnel supraconducteur selon la revendication 2 ou 4, caractérisé en que l'on a fait croître le matériau en oxyde magnétique (1) et les supraconducteurs du type oxyde (2) ayant la même structure cristalline dans une relation d'azimut épitaxiale.

6. Dispositif supraconducteur composé d'un élément de jonction à tunnel supraconducteur selon la revendication 3 et d'une électrode de grille (11) formée entre les supraconducteurs du type oxyde (9 ; 13) par l'intermédiaire d'une couche d'isolement (10).

7. Dispositif supraconducteur intégré composé d'une pluralité d'éléments de jonction à tunnel supraconducteur selon la revendication 3, dans lequel une couche d'inhibition d'interférence composée d'un matériau non magnétique et isolant est disposée entre les éléments.

8. Elément de photodétection composé d'un élément de jonction à tunnel supraconducteur selon la revendication 3 et d'une partie formant photorécepteur (14) formée entre eux.

9. Utilisation des éléments de jonction à tunnel supraconducteur selon la revendication 3 ou 8 pour détecter des ondes électromagnétiques.

10. Utilisation d'une pluralité de dispositifs supraconducteurs selon la revendication 6 dans des systèmes arithmétiques pour effectuer des opérations logiques.
